# EUROPEAN PATENT APPLICATION

(11) **EP 2 613 616 A2**
(43) Date of publication of application: **10.07.2013**
(21) Application number: 13150214.8
(22) Date of filing: 04.01.2013
(51) Int. Cl.: H05K 1/11

(54) **Flexible printed circuit for mounting light emitting element, and illumination apparatus, capsule endoscope and vehicle lighting apparatus incorporating the same**

(30) Priority: 05.01.2012 JP 2012000748; 25.10.2012 JP 2012236025
(71) Applicant: Canon Components, Inc., Kodama-gun Saitama 369-0393 (JP)
(72) Inventor: Uehara, Hiroharu, Kodama-gun, Saitama 369-0393 (JP)
(74) Representative: TBK

(57) **Abstract**

A flexible printed circuit for mounting a light emitting element has a base film, a wiring pattern formed on a surface of the base film, and a cover film that covers the base film and the wiring pattern. At least one of the base film and the cover film has a substrate comprising a metal. The cover film has such surface properties as to produce specular reflection or diffuse reflection of light or has a substantially white reflecting film on a surface of the cover film.

## Description

### CROSS-REFERENCE TO RELATED APPLICATIONS

This application is based upon and claims the benefit of priority of the prior Japanese Patent Application No. 2012-000748, filed on January 5, 2012, and the Japanese Patent Application No. 2012-236025, filed on October 25, 2012, the entire contents of which are incorporated herein by reference.

### BACKGROUND OF THE INVENTION

### [Field of the Invention]

The present invention generally relates to a flexible printed circuit for mounting a light emitting element, and an illumination apparatus, a capsule endoscope and a vehicle lighting apparatus incorporating the same. More specifically, the present invention relates to a flexible printed circuit for mounting a light emitting element that allows radiation of the heat generated by a light emitting element, such as a light emitting diode (LED), and efficient use of the light emitted by the light emitting element, and, an illumination apparatus, a capsule endoscope and a vehicle lighting apparatus incorporating the same.

### [Description of the Related Art]

A common conventional flexible printed circuit (FPC) comprises a base film and a predetermined wiring pattern formed on a surface of the base film. If necessary, the flexible printed circuit can further comprise a cover film over the surface of the wiring pattern. In use, various elements are mounted on the surface of the flexible printed circuit. The base film and the cover film of the flexible printed circuit are typically made of a resin material, such as polyimide (PI), polyethylene terephthalate (PET) and polyethylene naphthalate (PEN).

The flexible printed circuit configured as described above may pose the following problems when used as a substrate for mounting a light emitting element, such as a light emitting diode (LED). The LED used as a light emitting element deteriorates in characteristics at high temperatures and therefore needs to radiate heat in order to avoid becoming hot. In general, resin materials have low thermal conductivities, so that the flexible printed circuit, whose base film and cover film are made of a resin material, may be unable to sufficiently radiate the heat generated by the LED. In addition, in order to efficiently use the light emitted by the LED, the amount of light absorbed by the surface of the flexible printed circuit needs to be small. However, polyimide, which is used as the material of the base film and the cover film, is brown in color and therefore tends to absorb the light emitted by the LED, thereby reducing the amount of light available.

As a measure to radiate heat from a printed circuit with an LED mounted thereon, for example, an arrangement in which a metal radiator plate is disposed in close contact with the surface of the printed circuit opposite to the surface on which the LED is mounted is proposed (see Patent Document 1).

As another measure, there is proposed a flexible printed circuit comprising a metal substrate and a wiring pattern formed on the metal substrate with an insulating film interposed therebetween (see Patent Document 2). As a measure to allow efficient use of light, an arrangement incorporating a cover film having a surface with a predetermined reflectance is proposed (see Patent Documents 2 and 3). However, the arrangement in which the radiator plate is mounted on the back surface leads to an increase in cost. Furthermore, none of the prior-art documents described above discloses an arrangement that achieves both radiation of the heat generated by the LED and efficient use of the light emitted by the LED.
Patent Document 1: Japanese Laid-Open Patent Publication No. 2009-25679
Patent Document 2: Japanese Laid-Open Patent Publication No. 2007-110010
Patent Document 3: Japanese Laid-Open Patent Publication No. 2009-302110
Patent Document 4: Japanese Laid-Open Patent Publication No. 2010-232252

### SUMMARY OF THE INVENTION

In view of the circumstances described above, an object of the present invention is to provide a flexible printed circuit for mounting a light emitting element, such as an LED, that radiates heat generated by the light emitting element to prevent an increase of the temperature of the light emitting element and has a high surface reflectance to allow efficient use of light emitted by the light emitting element.

Another object is to provide a flexible printed circuit that has a high electromagnetic shielding capability as well as heat dissipation properties and electric insulating properties and can be bent, and an illumination apparatus, a capsule endoscope and a vehicle lighting apparatus incorporating the same.

To attain the objects described above, a flexible printed circuit for mounting a light emitting element according to the present invention comprises a base film having a substrate comprising a metal material, a wiring pattern formed on a surface of said base film, and a cover film that has such a surface property as to produce specular reflection or diffuse reflection of light and covers said wiring pattern.

Another flexible printed circuit for mounting a light emitting element according to the present invention comprises a base film having a substrate comprising a resin material, a wiring pattern formed on a surface of said base film, and a cover film that has a substrate comprising a metal material, has such a surface property as to produce specular reflection or diffuse reflection of light and covers said wiring pattern.

An illumination apparatus, a capsule endoscope and a vehicle lighting apparatus according to the present invention comprise a flexible printed circuit for mounting a light emitting element according to the present invention and a light emitting element mounted on said printed circuit.

### BRIEF DESCRIPTION OF THE DRAWINGS

Fig. 1 is a schematic perspective view showing a configuration of flexible printed circuits for mounting a light emitting element according to embodiments of the present invention;
Fig. 2A is a schematic cross-sectional view showing a configuration of a flexible printed circuit for mounting a light emitting element according to a first embodiment of the present invention;
Fig. 2B is a schematic cross-sectional view showing a configuration of the flexible printed circuit for mounting a light emitting element according to the first embodiment of the present invention;
Fig. 3A is a schematic cross-sectional view showing a configuration of a flexible printed circuit for mounting a light emitting element according to a second embodiment of the present invention;
Fig. 3B is a schematic cross-sectional view showing a configuration of the flexible printed circuit for mounting a light emitting element according to the second embodiment of the present invention;
Fig. 4 is a schematic cross-sectional view showing a configuration of a flexible printed circuit for mounting a light emitting element according to a third embodiment of the present invention;
Fig. 5A is a schematic cross-sectional view showing a configuration of a flexible printed circuit for mounting a light emitting element according to a fourth embodiment of the present invention;
Fig. 5B is a schematic cross-sectional view showing a configuration of the flexible printed circuit for mounting a light emitting element according to the fourth embodiment of the present invention;
Fig. 6A is a schematic cross-sectional view showing a configuration of a flexible printed circuit for mounting a light emitting element according to a fifth embodiment of the present invention;
Fig. 6B is a schematic cross-sectional view showing a configuration of the flexible printed circuit for mounting a light emitting element according to the fifth embodiment of the present invention;
Fig. 7A is a schematic cross-sectional view for illustrating a step of forming an opening in a base film and the first half of a step of forming a wiring pattern in a method of manufacturing flexible printed circuits for mounting a light emitting element according to embodiments of the present invention;
Fig. 7B is a schematic cross-sectional view for illustrating the step of forming an opening in a base film and the first half of the step of forming a wiring pattern in the method of manufacturing flexible printed circuits for mounting a light emitting element according to embodiments of the present invention;
Fig. 7C is a schematic cross-sectional view for illustrating the step of forming an opening in a base film and the first half of the step of forming a wiring pattern in the method of manufacturing flexible printed circuits for mounting a light emitting element according to embodiments of the present invention;
Fig. 7D is a schematic cross-sectional view for illustrating the step of forming an opening in a base film and the first half of the step of forming a wiring pattern in the method of manufacturing flexible printed circuits for mounting a light emitting element according to embodiments of the present invention;
Fig. 8A is a schematic cross-sectional view for illustrating the second half of the step of forming a wiring pattern in the method of manufacturing flexible printed circuits for mounting a light emitting element according to embodiments of the present invention;
Fig. 8B is a schematic cross-sectional view for illustrating the second half of the step of forming a wiring pattern in the method of manufacturing flexible printed circuits for mounting a light emitting element according to embodiments of the present invention;
Fig. 8C is a schematic cross-sectional view for illustrating the second half of the step of forming a wiring pattern in the method of manufacturing flexible printed circuits for mounting a light emitting element according to embodiments of the present invention;
Fig. 8D is a schematic cross-sectional view for illustrating the second half of the step of forming a wiring pattern in the method of manufacturing flexible printed circuits for mounting a light emitting element according to embodiments of the present invention;
Fig. 9A is a schematic cross-sectional view for illustrating a step of forming a cover film in the method of manufacturing the flexible printed circuit for mounting a light emitting element according to the first embodiment of the present invention;
Fig. 9B is a schematic cross-sectional view for illustrating a step of forming a cover film in the method of manufacturing the flexible printed circuit for mounting a light emitting element according to the first embodiment of the present invention;
Fig. 9C is a schematic cross-sectional view for illustrating a step of forming a cover film in the method of manufacturing the flexible printed circuit for mounting a light emitting element according to the first embodiment of the present invention;
Fig. 9D is a schematic cross-sectional view for illustrating a step of forming a cover film in the method of manufacturing the flexible printed circuit for mounting a light emitting element according to the first embodiment of the present invention;
Fig. 10A is a schematic cross-sectional view for illustrating a step of forming a cover film and a step of forming a reflecting film in a case where the reflecting film is made of a solder resist in the method of manufacturing the flexible printed circuit for mounting a light emitting element according to the second embodiment of the present invention;
Fig. 10B is a schematic cross-sectional view for illustrating the step of forming a cover film and the step of forming a reflecting film in the case where the reflecting film is made of a solder resist in the method of manufacturing the flexible printed circuit for mounting a light emitting element according to the second embodiment of the present invention;
Fig. 10C is a schematic cross-sectional view for illustrating the step of forming a cover film and the step of forming a reflecting film in the case where the reflecting film is made of a solder resist in the method of manufacturing the flexible printed circuit for mounting a light emitting element according to the second embodiment of the present invention;
Fig. 11A is a schematic cross-sectional view for illustrating the step of forming a cover film and the first half of the step of forming a reflecting film in a case where the reflecting film is made of a film in the method of manufacturing the flexible printed circuit for mounting a light emitting element according to the second embodiment of the present invention;
Fig. 11B is a schematic cross-sectional view for illustrating the step of forming a cover film and the first half of the step of forming a reflecting film in the case where the reflecting film is made of a film in the method of manufacturing the flexible printed circuit for mounting a light emitting element according to the second embodiment of the present invention;
Fig. 11C is a schematic cross-sectional view for illustrating the step of forming a cover film and the first half of the step of forming a reflecting film in the case where the reflecting film is made of a film in the method of manufacturing the flexible printed circuit for mounting a light emitting element according to the second embodiment of the present invention;
Fig. 12A is a schematic cross-sectional view for illustrating the step of forming a cover film and the second half of the step of forming a reflecting film in the case where the reflecting film is made of a film in the method of manufacturing the flexible printed circuit for mounting a light emitting element according to the second embodiment of the present invention;
Fig. 12B is a schematic cross-sectional view for illustrating the step of forming a cover film and the second half of the step of forming a reflecting film in the case where the reflecting film is made of a film in the method of manufacturing the flexible printed circuit for mounting a light emitting element according to the second embodiment of the present invention;
Fig. 13A is a schematic cross-sectional view for illustrating a step of forming a cover film in the method of manufacturing the flexible printed circuit for mounting a light emitting element according to the third embodiment of the present invention;
Fig. 13B is a schematic cross-sectional view for illustrating the step of forming a cover film in the method of manufacturing the flexible printed circuit for mounting a light emitting element according to the third embodiment of the present invention;
Fig. 14A is a schematic cross-sectional view showing a configuration of the flexible printed circuit for mounting a light emitting element according to an example of a sixth embodiment of the present invention;
Fig. 14B is a schematic cross-sectional view showing a configuration of the flexible printed circuit for mounting a light emitting element according to another example of the sixth embodiment of the present invention;
Fig. 15A is a schematic cross-sectional view showing a configuration of the flexible printed circuit for mounting a light emitting element according to another example of the sixth embodiment of the present invention;
Fig. 15B is a schematic cross-sectional view showing a configuration of the flexible printed circuit for mounting a light emitting element according to another example of the sixth embodiment of the present invention;
Fig. 16 is a schematic cross-sectional view showing a configuration of a capsule endoscope according to an embodiment of the present invention; and
Fig. 17 is a schematic cross-sectional view showing a configuration of a vehicle lighting apparatus according to an embodiment of the present invention.

### DETAILED DESCRIPTION OF THE PREFERRED EMBODIMENTS

In the following, embodiments of the present invention will be described in detail with reference to the drawings.

### (Configuration Common To Embodiments)

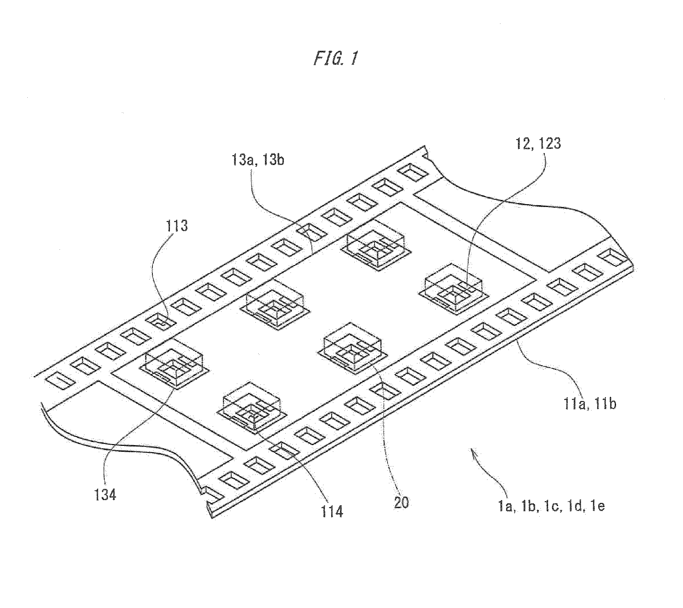

First, a common configuration of flexible printed circuits 1a to 1e for mounting a light emitting element according to embodiments of the present invention will be described with reference to Fig. 1. Fig. 1 is a schematic perspective view showing a general configuration of the flexible printed circuits 1a to 1e for mounting a light emitting element according to embodiments of the present invention. As shown in Fig. 1, the flexible printed circuits 1a to 1e for mounting a light emitting element according to embodiments comprise a base film 11a (11b), a wiring pattern 12, and a cover film 13a (13b). The wiring pattern 12 is formed on a surface of the base film 11a (11b), and the cover film 13a (13b) is disposed to cover the wiring pattern 12.

The base film 11a (11b) is a flexible film. The base film 11a (11b) has openings formed therein (through-holes penetrating the base film in the thickness direction), such as a sprocket hole 113 and a device hole 114. The sprocket hole 113 is used for feeding or positioning of the flexible printed circuits 1a to 1e for mounting a light emitting element according to embodiments in the process of mounting a light emitting element 20 or other predetermined elements on the flexible printed circuits 1a to 1e for mounting a light emitting element according to embodiments. The device hole 114 is a mounting opening into which a semiconductor device or the like is mounted. The sprocket hole is not essential if the feeding or positioning function of the sprocket hole is served by other means. Similarly, the device hole 114 is not essential if a surface-mount light emitting element is to be mounted.

The wiring pattern 12 is a thin film pattern of a conductor, such as a metal material. For example, the wiring pattern 12 is formed of a copper film having a thickness of approximately 8 to 50 µm. The specific configuration of the wiring pattern 12 is not particularly limited and can be appropriately determined considering the circuit configuration of the flexible printed circuit for mounting a light emitting element according to each embodiment. The cover film 13a (13b) is disposed to cover the surface of the flexible printed circuits 1a to 1e for mounting a light emitting element according to embodiments on which the light emitting element 20 is mounted. The cover film 13a has such surface properties as to produce specular reflection of light or such surface irregularities as to produce diffuse reflection of light. Alternatively, the cover film 13a (13b) may have a substantially white reflecting film 16 (133) on a surface thereof. The reflecting film 16 (133) is a substantially white coating or film and produces diffuse reflection by the action of a white pigment contained therein (as described later). The cover film 13a (13b) (or the reflecting film 16 (133) on the surface thereof) has a function of allowing efficient use of the light emitted by the light emitting element 20 mounted on the flexible printed circuits 1a to 1e for mounting a light emitting element according to embodiments by reflecting the light emitting element 20. The cover film 13a (13b) further has a function of protecting the wiring pattern 12. The cover film 13a (13b) has an opening 134 formed therein (a through-hole penetrating the cover film in the thickness direction). A predetermined part of the wiring pattern 12 is exposed in the opening 134.

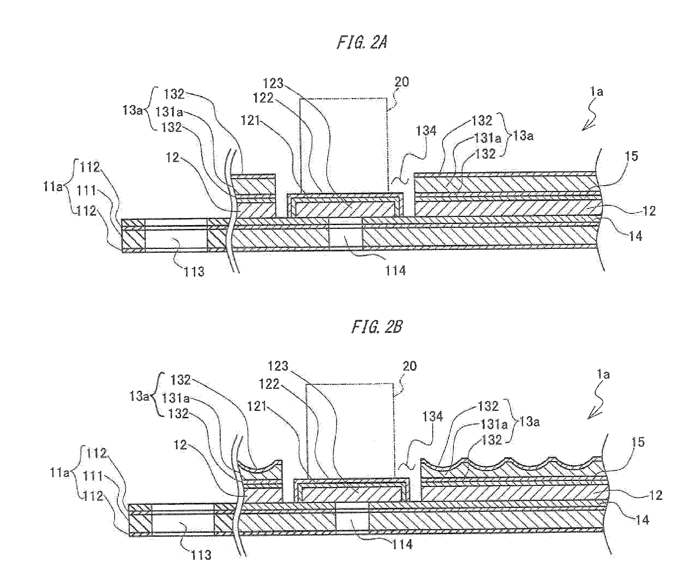

The part of the wiring pattern 12 exposed in the opening 134 may be a contact pad 123 or an inner lead (not shown). The contact pad 123 is a part for electrically connecting the light emitting element 20 or other predetermined electronic parts to the wiring pattern 12. The contact pad 123 functions also as a contact (terminal) of the flexible printed circuits 1a to 1e for mounting a light emitting element according to embodiments of the present invention to be electrically connected to an external apparatus. Furthermore, a nickel-plating film 121 and a gold-plating film 122 are formed one on another on the surface of the exposed part of the wiring pattern 12 (see Figs. 2A to 7D).

The base film 11a and the cover film 13a have substrates 111 and 131a made of a metal material, respectively.

With the flexible printed circuits 1a to 1e for mounting a light emitting element according to embodiments of the present invention, the light emitting element 20 can be soldered or otherwise mounted to the wiring pattern 12 (contact pad 123) exposed in the opening 134. In Fig. 1, the light emitting element 20 to be mounted is shown by an alternate short and long dash line.

Next, each of the flexible printed circuits 1a to 1e for mounting a light emitting element according to embodiments will be described. Figs. 2A to 6B are schematic cross-sectional views showing configurations of the flexible printed circuits 1a to 1e for mounting a light emitting element according to embodiments of the present invention. Note that Figs. 2A to 6B are schematic diagrams given for illustrative purposes and do not illustrate any specific actually possible cross-sectional configuration.

### (First Embodiment)

The flexible printed circuit 1a for mounting a light emitting element according to a first embodiment of the present invention will be described with reference to Figs. 2A and 2B. Figs. 2A and 2B are schematic cross-sectional views showing configurations of the flexible printed circuit 1a for mounting a light emitting element according to the first embodiment of the present invention. Fig. 2A shows a configuration in which the surface of a cover film 13a has no irregularities, and Fig. 2B shows a configuration in which the surface of the cover film 13a has irregularities.

As shown in Figs. 2A and 2B, a base film 11a of the flexible printed circuit 1a for mounting a light emitting element according to the first embodiment has a laminate structure comprising a film-shaped substrate 111 and protective films 112 formed on the surfaces of the substrate 111, The substrate 111 is made of a metal material. The substrate 111 is an aluminum film having a thickness of 8 to 100 µm, for example. The protective film 112 is made of an electrically insulating material. The protective film 112 is a polyimide (PI) film having a thickness of several µm, for example. A film of an adhesive 14 is formed on a surface of the base film 11a, and a wiring pattern 12 is bonded to the surface of the base film 11a by the adhesive 14. The adhesive can be any of various well-known thermosetting adhesives (or any of various well-known thermosetting resin materials).

The cover film 13a comprises a film-shaped substrate 131a made of a metal material and protective films 132 formed on the surfaces of the substrate 131a. The substrate 131a is an aluminum film having a thickness of 8 to 100 µm that has such surface properties as to produce specular reflection of light, for example. The protective film 132 is a polyimide film having a thickness of approximately 4 µm, for example. Polyimide is a resin material that is brown in color but appears substantially transparent at small thicknesses.

Thus, the surface of the cover film 13a shows the gloss of the metal of the substrate 131a and has substantially the same surface properties as the substrate 131a in terms of light reflection that produce specular reflection of light. Therefore, the reflectance of the surface of the cover film 13a is higher than that of a film made of a resin material alone. The cover film 13a is bonded to the surface of the wiring pattern 12 and the base film 11a by a thermosetting adhesive 15, for example. The cover film 13a has the opening 134 formed at a predetermined position. A predetermined part (a contact pad 123, for example) of the wiring pattern 12 is exposed in the opening 134. The position, the dimensions and the shape of the opening 134 can be appropriately determined considering the positions of other predetermined elements including a light emitting element 20 to be mounted and the dimensions and shapes of the other predetermined elements including the light emitting element 20.

The surface of the cover film 13a may be a substantially planar surface having no irregularities as shown in Fig. 2A or a surface having irregularities as shown in Fig. 2B.

If the surface of the cover film 13a has no irregularities as shown in Fig. 2A, the cover film 13a produces specular reflection of light. In this case, the surface roughness Ra of the aluminum film forming the substrate 131a falls within a range of 0.03 to 0.05 µm or is smaller than the range. With such a configuration, the light emitted by the light emitting element 20 is specularly reflected by the surface of the cover film 13a. The amount of light wasted can be reduced, so that the number of light emitting elements 20 to be mounted can be reduced without decreasing the amount of light.

On the other hand, if the surface of the cover film 13a has irregularities as shown in Fig. 2B, the cover film 13a produces diffuse reflection of light. The irregularities are preferably depressions having a depth of 15 to 80 µm formed in pitch of 100 to 3000 µm, for example. In general, an LED emits light with high directivity. If the light emitting element 20 is an LED, the surface of the cover film 13a can produce diffuse reflection of the light emitted by the LED, thereby decreasing the directivity of the light and reducing the nonuniformity of the in-plane light intensity distribution. Thus, the light emitted by the light emitting element 20 can be efficiently used, and the in-plane intensity distribution of the light can be made uniform. For example, in a case where a surface light source is formed by the flexible printed circuit 1a for mounting a light emitting element according to the first embodiment, the plurality of LEDs mounted can be arranged at greater intervals while preventing the in-plane light intensity distribution from being nonuniform. Therefore, the number of light emitting elements 20 to be mounted can be reduced. Since the substrate 131a of the cover film 13a is made of a metal material, such as aluminum, the irregularities can be easily formed on the surface in a transfer molding process or the like.

The surface of the cover film 13a may or may not have the irregularities depending on the application of the flexible printed circuit 1a for mounting a light emitting element according to the first embodiment.

Furthermore, a nickel-plating film 121 and a gold-plating film 122 are formed one on another on the surface of the part (the contact pad 123, for example) of the wiring pattern 12 exposed in the opening 134 of the cover film 13a.

With the flexible printed circuit 1a for mounting a light emitting element according to the first embodiment, both the base film 11a and the cover film 13a have the substrates 111 and 131a made of a metal material, respectively. Metal materials have higher thermal conductivities than resin materials. Thus, the heat generated by the mounted light emitting element 20 can be quickly radiated through the base film 11a and the cover film 13a. Therefore, the temperature of the light emitting element 20 can be prevented from increasing, and thereby preventing the properties of the light emitting element 20 from being deteriorated by heat. In addition, the cover film 13a is disposed on the surface on which the light emitting element 20 is mounted. The surface of the cover film 13a shows the gloss of the metal of the substrate 131a and has a higher reflectance than a film made of a resin material alone. Therefore, more of the light emitted by the light emitting element 20 can be reflected rather than absorbed. As described above, the flexible printed circuit 1a for mounting a light emitting element according to the first embodiment can prevent the temperature of the mounted light emitting element 20 from increasing and allow efficient use of the light emitted by the light emitting element 20.

### (Second Embodiment)

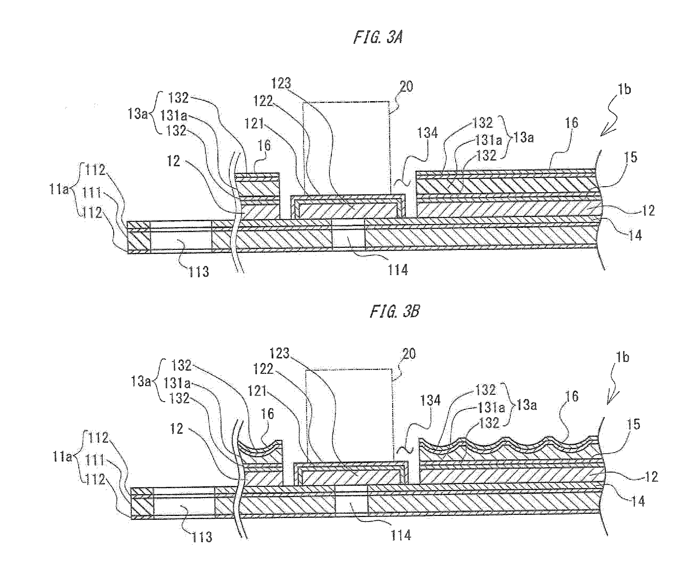

Next, the flexible printed circuit 1b for mounting a light emitting element according to a second embodiment of the present invention will be described with reference to Figs. 3A and 3B. The same components as those of the flexible printed circuit 1a for mounting a light emitting element according to the first embodiment are denoted by the same reference numerals, and descriptions thereof may be omitted. Figs. 3A and 3B are schematic cross-sectional views showing configurations of the flexible printed circuit 1b for mounting a light emitting element according to the second embodiment of the present invention. Fig. 3A shows a configuration in which the surface of a reflecting film 16 has no irregularities, and Fig. 3B shows a configuration in which the surface of the reflecting film 16 has irregularities.

As shown in Figs. 3A and 3B, a base film 11a, a wiring pattern 12, and a cover film 13a are the same as those of the flexible printed circuit 1a for mounting a light emitting element according to the first embodiment. Therefore, descriptions thereof will be omitted.

According to this embodiment, the reflecting film 16 is formed on the surface of the cover film 13a. The reflecting film 16 is a substantially white thermosetting solder resist film or other film having a substantially white surface.

The solder resist may be the white thermosetting solder resist with high reflectance (model number: PSR-4000 LEW&W series) manufactured by TAIYO INK MFG CO., LTD., for example. If this solder resist is used, the reflecting film 16 can have a thickness of approximately 15 to 50 µm. With such a configuration, the flexible printed circuit 1b for mounting a light emitting element according to the second embodiment can have an increased surface reflectance.

The film having a substantially white surface may be a film having a laminate structure comprising a substrate formed by a film made of a resin material and a coating film formed on a surface of the substrate. For example, the reflecting film 16 may comprise a polyimide film having a thickness of 8 to 50 µm serving as the substrate and a film containing titanium oxide having a thickness of 10 to 75 µm serving as the coating film.

With such a configuration, the surface of the cover film 13a can be substantially white in color and have an increased reflectance.

The surface of the reflecting film 16 may be a surface having no irregularities as shown in Fig. 3A or a surface having irregularities as shown in Fig. 3B. The configuration of the irregularities formed on the surface of the reflecting film 16 is the same as that of the flexible printed circuit 1a for mounting a light emitting element according to the first embodiment. Therefore, descriptions thereof will be omitted.

With the flexible printed circuit 1b for mounting a light emitting element according to the second embodiment, both the base film 11a and the cover film 13a have the substrates 111 and 131a made of a metal material, respectively. Metal materials have higher thermal conductivities than resin materials, so that the heat generated by the mounted light emitting element 20 can be quickly radiated through the base film 11a and the cover film 13a. Therefore, the temperature of the light emitting element 20 can be prevented from increasing, and thereby preventing the properties of the light emitting element 20 from being deteriorated by heat. In addition, the cover film 13a is disposed on the surface on which the light emitting element 20 is mounted, and the substantially white reflecting film 16 is formed on the surface of the cover film 13a. The reflecting film 16 has a higher reflectance than common resin materials (polyimide, for example) used for protecting printed circuits. Therefore, more of the light emitted by the light emitting element 20 can be reflected rather than absorbed. As described above, the flexible printed circuit 1b for mounting a light emitting element according to the second embodiment can prevent the temperature of the mounted light emitting element 20 from increasing and allow efficient use of the light emitted by the light emitting element 20.

The effects and advantages of the irregularities formed on the surface of the reflecting film 16 as well as the differences in effects and advantages between the presence and absence of the irregularities are the same as those of the flexible printed circuit 1a for mounting a light emitting element according to the first embodiment.

### (Third Embodiment)

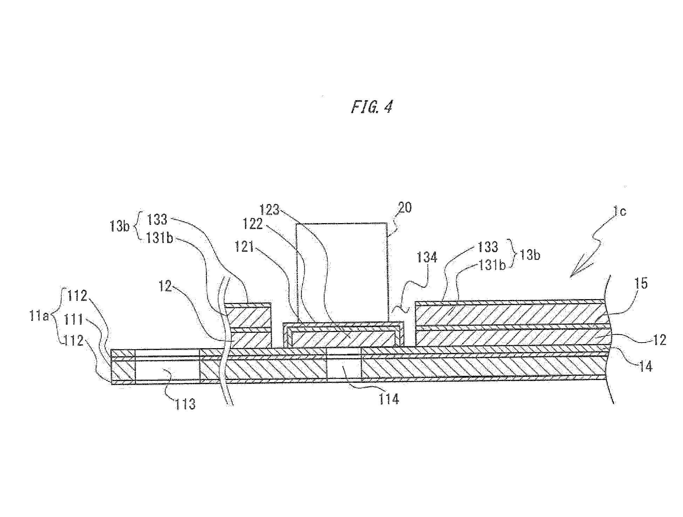

Next, the flexible printed circuit 1c for mounting a light emitting element according to a third embodiment of the present invention will be described with reference to Fig. 4. Fig. 4 is a schematic cross-sectional view showing a configuration of the flexible printed circuit 1c for mounting a light emitting element according to the third embodiment of the present invention.

A base film 11a and a wiring pattern 12 of the flexible printed circuit 1c for mounting a light emitting element according to the third embodiment are the same as those of the flexible printed circuit 1a for mounting a light emitting element according to the first embodiment. Therefore, descriptions thereof will be omitted.

A cover film 13b is formed on the surface of the wiring pattern 12. The cover film 13b comprises a substrate 131b formed by a film made of a resin material and a substantially white reflecting film 133 formed on the surface of the substrate 131b. The substrate 131b can be a polyimide film having a thickness of 8 to 50 µm, for example. The substantially white reflecting film 133 can be a film containing titanium oxide having a thickness of 10 to 75 µm, for example. With such a configuration, the surface of the cover film 13b can have an increased reflectance. A film of an adhesive 15 is formed on the surface of the substrate 131b facing an adhesive 14 on the surface of the base film, and the cover film 13b is bonded to the surface of a wiring pattern 12 and the base film 11a by the adhesive 15.

With the flexible printed circuit 1c for mounting a light emitting element according to the third embodiment, the base film 11a is a film comprising the substrate 111 made of a metal material. Metal materials have higher thermal conductivities than resin materials, so that the heat generated by the mounted light emitting element 20 can be quickly radiated through the base film 11a. Therefore, the temperature of the light emitting element 20 can be prevented from increasing, and thereby preventing the properties of the light emitting element 20 from being deteriorated by heat. In addition, the cover film 13b is disposed on the surface on which the light emitting element 20 is mounted. The cover film 13b has the substantially white reflecting film 133 as the surface thereof. Therefore, more of the light emitted by the light emitting element 20 can be reflected rather than absorbed. As described above, the flexible printed circuit 1c for mounting a light emitting element according to the third embodiment can prevent the temperature of the mounted light emitting element 20 from increasing and allow efficient use of the light emitted by the light emitting element 20.

### (Fourth Embodiment)

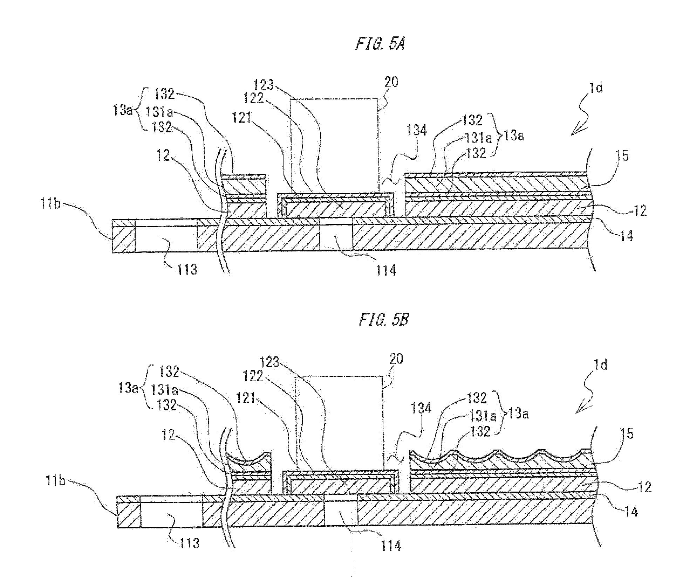

Next, the flexible printed circuit 1d for mounting a light emitting element according to a fourth embodiment of the present invention will be described with reference to Figs. 5A and 5B. Figs. 5A and 5B are schematic cross-sectional views showing configurations of the flexible printed circuit 1d for mounting a light emitting element according to the fourth embodiment of the present invention. Fig. 5A shows a configuration in which the surface of a cover film 13a has no irregularities, and Fig. 5B shows a configuration in which the surface of the cover film 13a has irregularities, The same components as those of the flexible printed circuit 1a for mounting a light emitting element according to the first embodiment are denoted by the same reference numerals, and descriptions thereof may be omitted.

A base film 11b of the flexible printed circuit 1d for mounting a light emitting element according to the fourth embodiment is made of a resin material. For example, the base film 11b is a polyimide film having a thickness of 8 to 125 µm. A film of an adhesive 14 is formed on a surface of the base film 11b. A wiring pattern 12 is bonded to the surface of the base film 11b by the adhesive 14. The adhesive 14, the wiring pattern 12 and the cover film 13a are the same as those of the flexible printed circuit 1a for mounting a light emitting element according to the first embodiment. Therefore, descriptions thereof will be omitted.

The surface of the cover film 13a may be a surface having no irregularities as shown in Fig. 5A or a surface having irregularities as shown in Fig. 5B. The configuration of the irregularities formed on the surface of the cover film 13a is the same as that of the flexible printed circuit 1a for mounting a light emitting element according to the first embodiment.

As described above, with the flexible printed circuit 1d for mounting a light emitting element according to the fourth embodiment, the cover film 13a is a film comprising a substrate 131a made of a metal material. Metal materials have higher thermal conductivities than resin materials, so that the heat generated by the mounted light emitting element 20 can be quickly radiated through the cover film 13a. Therefore, the temperature of the light emitting element 20 can be prevented from increasing, and thereby preventing the properties of the light emitting element 20 from being deteriorated by heat. In addition, the surface of the cover film 13a shows the gloss of the metal of the substrate 131a and has a high reflectance. Therefore, more of the light emitted by the light emitting element 20 can be reflected rather than absorbed. As described above, the flexible printed circuit 1d for mounting a light emitting element according to the fourth embodiment can prevent the temperature of the mounted light emitting element 20 from increasing and allow efficient use of the light emitted by the light emitting element 20.

The effects and advantages of the irregularities formed on the surface of the cover film 13a as well as the differences in effects and advantages between the presence and absence of the irregularities are the same as those of the flexible printed circuit 1a for mounting a light emitting element according to the first embodiment.

### (Fifth Embodiment)

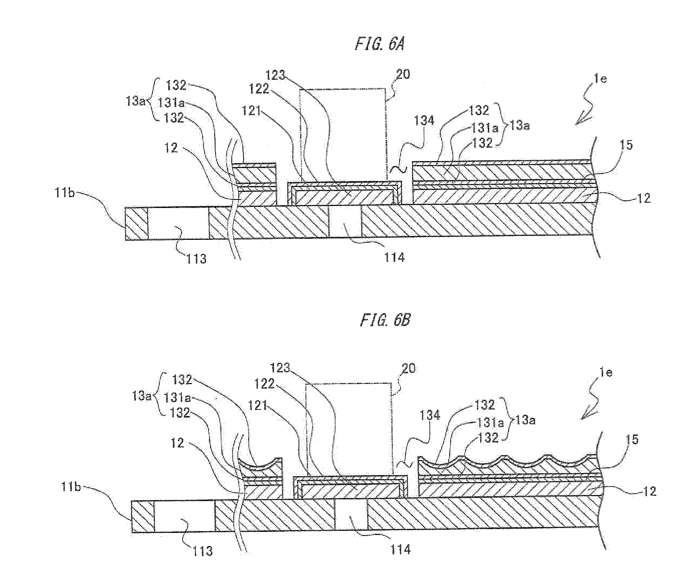

Next, the flexible printed circuit 1e for mounting a light emitting element according to a fifth embodiment of the present invention will be described with reference to Figs. 6A and 6B. Figs. 6A and 6B are schematic cross-sectional views showing configurations of the flexible printed circuit 1e for mounting a light emitting element according to the fifth embodiment of the present invention. Fig. 6A shows a configuration in which the surface of a cover film 13a has no irregularities, and Fig. 6B shows a configuration in which the surface of the cover film 13a has irregularities. The same components as those of the flexible printed circuit 1d for mounting a light emitting element according to the fourth embodiment are denoted by the same reference numerals, and descriptions thereof may be omitted.

A base film 11b, a wiring pattern 12 and the cover film 13a of the flexible printed circuit 1e for mounting a light emitting element according to the fifth embodiment are the same as those of the flexible printed circuit 1d for mounting a light emitting element according to the fourth embodiment. Therefore, descriptions thereof will be omitted. In the flexible printed circuit 1d for mounting a light emitting element according to the fourth embodiment, the wiring pattern 12 is bonded to the base film 11b by the adhesive 14. However, in the flexible printed circuit 1e for mounting a light emitting element according to the fifth embodiment, no film of the adhesive 14 is formed between the wiring pattern 12 and the base film 11b. In such a configuration, the wiring pattern 12 can be formed of a copper film with a varnish-like polyimide resin applied thereto and dried and thermally set (that is, an adhesive-less copper clad laminate formed by casting). The flexible printed circuit 1e for mounting a light emitting element configured as described above has no film of the adhesive 14 unlike the flexible printed circuit 1d for mounting a light emitting element according to the fourth embodiment and therefore can quickly radiate the heat generated by the mounted light emitting element 20 to the base film 11b through the cover film 13a and the wiring pattern.

### (Manufacturing Method)

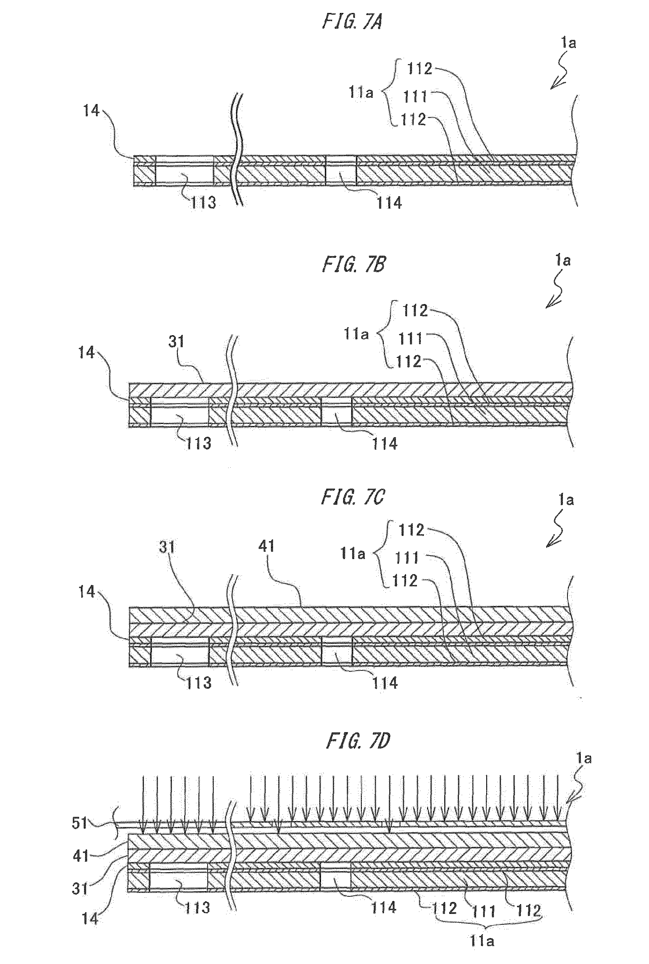

Next, methods of manufacturing the flexible printed circuits 1a to 1e for mounting a light emitting element according to embodiments of the present invention will be described with reference to Figs. 7A to 13B. The methods of manufacturing the flexible printed circuits 1a to 1e for mounting a light emitting element according to embodiments of the present invention comprise a step of forming openings in the base film 11a (11b), a step of forming the wiring pattern 12, a step of forming a cover film 13a (13b), and a step of plating the wiring pattern 12. The method of manufacturing the flexible printed circuit 1b for mounting a light emitting element according to the second embodiment further comprises a step of forming the reflecting film 16. In the case where the surface of the cover film 13a (13b) or the reflecting film 16 has irregularities, the methods further comprise a step of forming the irregularities.

The step of forming openings in the base film 11a (11b) and the step of forming the wiring pattern 12 are the same for the methods of manufacturing the flexible printed circuits 1a to 1e for mounting a light emitting element according to embodiments and therefore will be described together. Figs. 7A to 8D are schematic cross-sectional views for illustrating the step of forming openings in the base film 11a (11b) and the step of forming the wiring pattern 12. Although Figs. 7A to 8D show the flexible printed circuit 1a for mounting a light emitting element according to the first embodiment as an example, the same description holds true for the flexible printed circuits 1b to 1e for mounting a light emitting element according to the second to fifth embodiments.

As shown in Fig. 7A, first, openings, such as the sprocket hole 113 and the device hole 114, are formed in the base film 11a (11b) with the thermosetting adhesive 14 applied thereto partially set. The openings can be formed by punching using a die, for example.

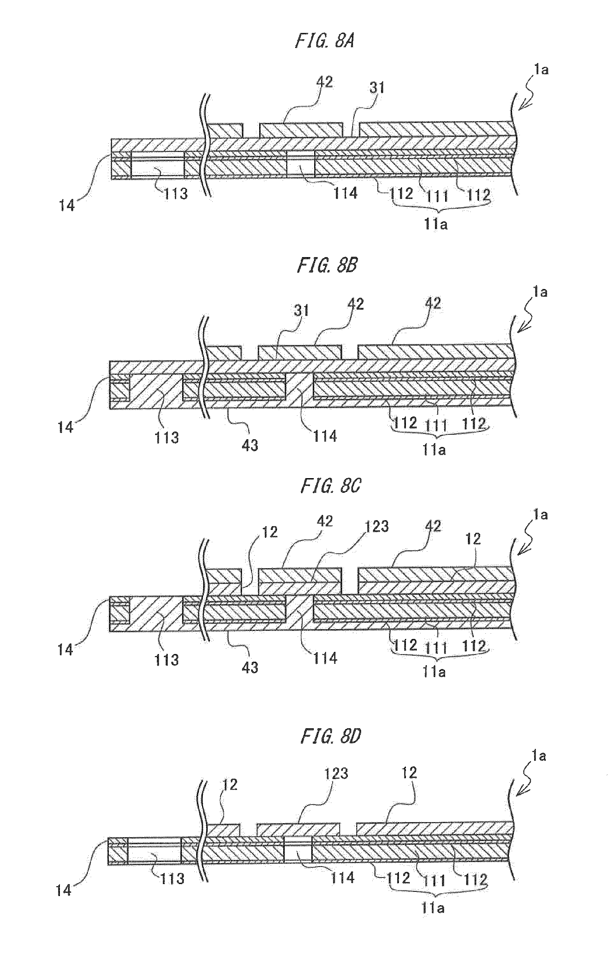

Then, the process proceeds to the step of forming the wiring pattern 12 as shown in Figs. 7B to 8D. In this step, the wiring pattern 12 is formed on a surface of the base film 11a (11b). The wiring pattern 12 can be formed by photolithography. More specifically, the wiring pattern 12 is formed as follows. As shown in Fig. 7B, a conductor film 31 is applied onto the base film 11a (11b) with the film of the adhesive 14 formed thereon. The conductor film 31 is to be patterned to form the wiring pattern 12. The conductor film 31 can be applied by thermo-compression bonding (laminating), for example. Then, the thermosetting adhesive 14 between the base film 11a (11b) and the conductor film 31 is set in a curing process. In this way, the conductor film 31 is bonded to the surface of the base film 11a (11b). Then, as shown in Fig. 7C, a film of a photoresist 41 is formed on the surface of the conductor film 31. The photoresist 41 is not limited to any particular type and can be any of various well-known photosensitive materials. The film of the photoresist 41 can be formed by various well-known conventional methods. For example, the surface of the conductor film 31 can be coated with the photoresist 41 in a roll-to-roll process, and then the photoresist 41 can be dried. Then, as shown in Fig. 7D, the formed film of the photoresist 41 is exposed to light. The arrows in the drawing schematically show the optical energy with which the film of the photoresist 41 is irradiated. The exposure can be performed by using a photomask 51 with a predetermined light transmitting part and a predetermined light blocking part and irradiating a predetermined part of the film of the photoresist 41 with the optical energy through the photomask 51. The photoresist 41 may be of the positive type or the negative type. The drawings show an example in which the photoresist 41 is of the positive type (the part irradiated with the optical energy becomes soluble in the developer). Then, as shown in Fig. 8A, the exposed film of the photoresist 41 is developed. By the development, a resist pattern 42 formed by the photoresist 41 is formed on the surface of the conductor film 31. Then, as shown in Fig. 8B, a masking film 43 is formed on the surface opposite to the surface on which resist pattern 42 is formed. The masking film 43 protects the conductor film 31 in the process of forming the wiring pattern 12 by patterning the conductor film 31 by etching. That is, the masking film 43 prevents the conductor film 31 from being etched through the openings formed in the base film 11a (11b). In the case where the substrate 111 of the base film 11a is made of a metal material, the masking film 43 protects the substrate 111 (aluminum film) of the base film 11a (prevents the substrate 111 from being etched) in this step. The masking film 43 can be made of any of various well-known thermosetting etching resists. The masking film 43 can be formed by coating the surface of the base film 11a (11b) (the surface opposite to the surface to which the conductor film 31 is applied, in this example) with the thermosetting etching resist that is to form the masking film 43 so as to fill the openings 113 and 114 and then setting the thermosetting etching resist by heating, for example. Once the masking film 43 is formed, the base film 11a (11b) and the conductor film 31 exposed in the openings (the sprocket holes 113 and the device holes 114) in the base film 11a (11b) are covered with the masking film 43. That is, the openings formed in the base film 11a (11b) are filled with the thermosetting etching resist forming the masking film 43. Then, as shown in Fig. 8C, the conductor film 31 is etched using the resist pattern 42 as an etching mask. By this etching, the conductor film 31 is patterned to form the wiring pattern 12. Note that since the openings including the device holes 114 are covered with the masking film 43 as described above and shown in Figs. 8B and 8C, the substrate 111 of the base film 11a (11b) is not etched. That is, the masking film 43 protects the conductor film 31 and the substrate 111 of the base film 11a. Once the etching is completed, as shown in Fig. 8D, the resist pattern 42 and the masking film 43 are removed (peeled off). The resist pattern 42 and the masking film 43 can be removed using caustic soda, for example. The wiring pattern 12 is formed by the procedure described above.

Then, the process proceeds to the step of forming the cover film 13a (13b) and the step of forming the reflecting film 16 (133). In the following, the step of forming the cover film 13a (13b) and the step of forming the reflecting film 16 (133) in each embodiment will be separately described.

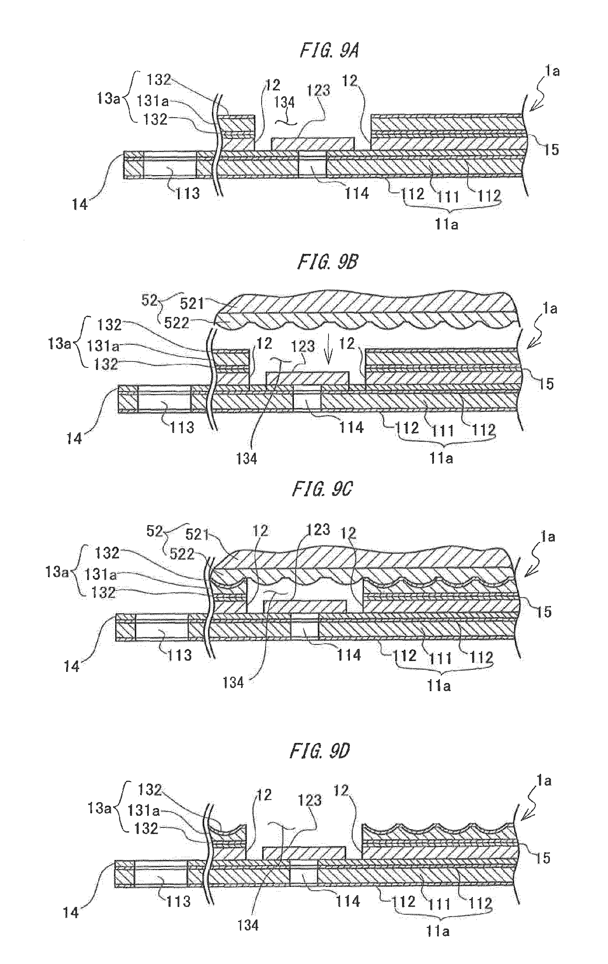

The step of forming the cover film 13a of the flexible printed circuit 1a for mounting a light emitting element according to the first embodiment will be described with reference to Figs. 9. Figs. 9A to 9D are schematic diagrams for illustrating the step of forming the cover film 13a of the flexible printed circuit 1a for mounting a light emitting element according to the first embodiment. Note that the step of forming the cover film 13a of the flexible printed circuits 1d and 1e for mounting a light emitting element according to the fourth and fifth embodiments are the same as the step of forming the cover film 13a of the flexible printed circuit 1a for mounting a light emitting element according to the first embodiment.

As shown in Fig. 9A, first, the cover film 13a is formed on a surface of the base film 11a and wiring pattern 12. More specifically, the adhesive 15 is applied to the surface of the cover film 13a facing the base film 11a and wiring pattern 12 to bond the cover film 13a to the base film 11a and wiring pattern 12.

For example, the cover film 13a can be a composite sheet previously coated with a film of the adhesive 15. A method of manufacturing the composite sheet will be briefly described. First, using a base and a roll type coater, a solution of the adhesive 15 is applied to a surface of the cover film 13a to form a film of the adhesive 15. The film of the adhesive 15 formed on the cover film 13a is partially set by evaporating the organic solvent with a drier. The conditions for drying with the drier can be appropriately set considering the kind of the adhesive, the thickness of the film or the like. The adhesive 15 can be any of various well-known thermosetting adhesives.

The cover film 13a and the adhesive 15 applied thereto are previously shaped to have a predetermined shape and predetermined dimensions (that is, so as to have the shape and the dimensions of the region to be covered by the cover film 13a) and have the openings 134 previously formed therein. The openings 134 can be formed in the cover film 13a by punching with a die, for example. Then, the cover film 13a having the predetermined shape and the predetermined dimension is positioned on and temporarily bonded to the surface of the base film 11a and wiring pattern 12. Then, the cover film 13a is permanently bonded to the surface with a thermo-compression laminator or the like and then is subjected to after-baking. In this way, the cover film 13a is bonded to the surface of the base film 11a and wiring pattern 12 at a predetermined position.

Then, irregularities are formed on the surface of the cover film 13a. The irregularities are formed with a transfer mold 52. As shown in Figs. 9B to 9D, the transfer mold 52 is pressed against the surface of the cover film 13a. The transfer mold 52 comprises a cushion rubber 521 and a glass cloth 522 applied to a surface of the cushion rubber 521.

The glass cloth 522 is a film-shaped member made of a glass fiber. Therefore, the surface of the glass cloth 522 has irregularities determined by the diameter and the pitch of the glass fibers. When the glass cloth 522 is pressed against the cover film 13a, the irregularities on the surface of the glass cloth 522 are transferred to the surface of the cover film 13a. Irregularities having a depth of 15 to 80 µm can be formed on the surface in pitch of 100 to 3000 µm by changing the kind of the glass fiber. Through this step, the cover film 13a comes to have irregularities on the surface and thus have such surface properties as to produce diffuse reflection of light.

The depth and the pitch of the irregularities on the surface of the glass cloth 522 can be appropriately chosen so as to form irregularities that produce diffuse reflection of light on the surface of the cover film 13a. For example, the depth of the irregularities on the surface of the glass cloth 522 can be approximately 200 µm in the longitudinal direction of the glass cloth 522 and approximately 30 µm in the lateral direction of the glass cloth 522, and the pitch of the irregularities can be approximately 2.5 mm. If the transfer mold 52 comprising such a glass cloth 522 is used, irregularities having a depth of approximately 15 µm can be formed on the surface of the cover film 13a, for example. In this way, the cover film 13a comes to have such surface properties as to produce diffuse reflection of light. These numerical values are given for illustrative purposes, and the present invention is not limited to these values. What is essential is that irregularities that produce diffuse reflection of light can be formed on the surface of the cover film 13a. The glass cloth 522 according to this embodiment can be CHUKOH FLO FABRIC (model number: FGF-400-35) manufactured by CHUKOH CHEMICAL INDUSTRIES, LTD. (CHUKOH FLO is a registered trademark of CHUKOH CHEMICAL INDUSTRIES, LTD.), for example.

According to the process of pressing the transfer mold 52 against the cover film 13a, irregularities can be formed on the surface of the cover film 13a without damaging the protective film 132. If a cutting process is used, the protective film 132 is shaved, and shavings or other contaminants are produced, unlike the process of pressing the transfer mold 52 against the cover film 13a. In addition, according to the process of forming irregularities with the transfer mold 52, the deformation of the wiring pattern 12 and the base film 11a can be reduced to a negligible extent.

In the case where the irregularities are not formed on the surface of the cover film 13a (see Fig. 2A), the step described above is not performed.

Then, a curing process is performed. By the curing process, the thermosetting adhesive 15 between the cover film 13a and the base film 11a and wiring pattern 12 is set.

Through the process described above, the cover film 13a is disposed on the surface of the base film 11a and wiring pattern 12.

Then, the nickel-plating film 121 is formed on the exposed wiring pattern 12, and the gold-plating film 122 is formed on the surface of the nickel-plating film 121 (see Figs. 2A and 2B).

Through the process described above, the flexible printed circuit 1a for mounting a light emitting element according to the first embodiment is manufactured.

Next, the step of forming the cover film 13a of the flexible printed circuit 1b for mounting a light emitting element according to the second embodiment and the step of forming the reflecting film 16 of the same will be described. The process varies depending on whether the reflecting film 16 is a coating or a film.

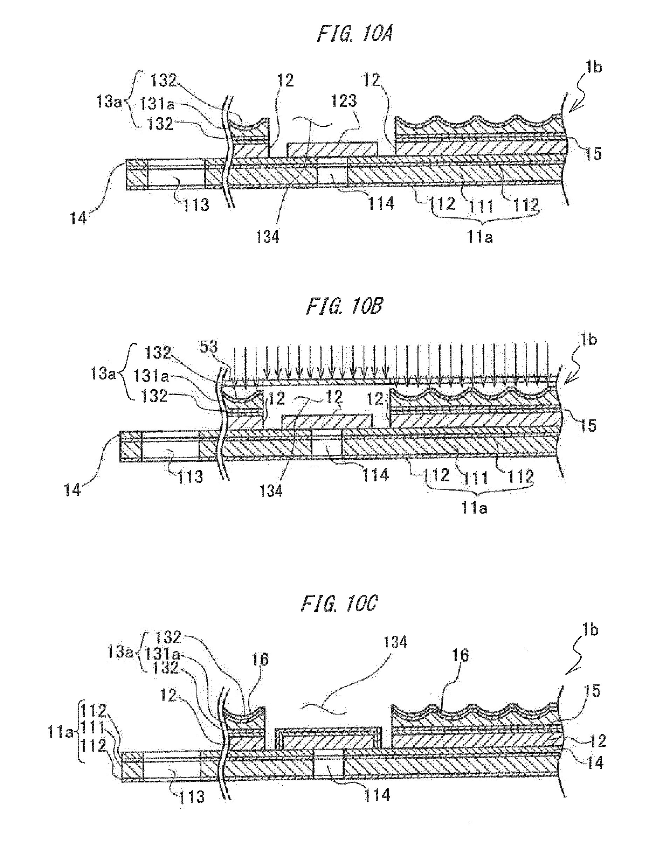

The process in the case where the reflecting film 16 is a coating is as follows. Figs. 10A to 10C are schematic cross-sectional views for illustrating the step of forming the cover film 13a of the flexible printed circuit 1b for mounting a light emitting element according to the second embodiment and the step of forming the reflecting film 16 that is a coating.

As shown in Fig. 10A, the cover film 13a is formed on the surface of the base film 11a and wiring pattern 12. As required, irregularities are formed on the surface of the cover film 13a. This step is the same as the step of forming the cover film 13a of the flexible printed circuit 1a for mounting a light emitting element according to the first embodiment. Therefore, descriptions thereof will be omitted.

Then, as shown in Fig. 10B, a mask 53 is disposed over the surface of the base film 11a with the cover film 13a formed thereon. The mask 53 has an opening 134 (through-hole) at a part where the reflecting film 133 is to be formed and is filled at the other parts. Then, a substantially white solder resist yet to be set is sprayed onto the surface of the cover film 13a through the mask 53. The arrows in the drawing schematically show the sprayed solder resist. Then, the sprayed solder resist is set. Through the process described above, the reflecting film 16 is formed on the surface of the cover film 13a as shown in Fig. 10C. According to this process, the reflecting film 16 having a uniform small thickness can be formed. Therefore, the surface of the reflecting film 16 can conform to the shape of the surface of the cover film 13a. If silk-screen printing is used, for example, the resulting reflecting film 16 is thick. Then, the irregularities formed on the surface of the cover film 13a are filled by the reflecting film 16, and the surface of the reflecting film 16 is substantially planar. To the contrary, according to the process of forming the reflecting film 16 by spraying, the resulting reflecting film can have a uniform small thickness. Therefore, the surface of the reflecting film 16 can conform to the shape of the surface of the cover film 13a. According to this process, the reflecting film 16 having irregularities on the surface can be formed.

Although Figs. 10A to 10C show a configuration in which irregularities are formed on the surface of the cover film 13a, the same process can be used to form the reflecting film 16 even if the irregularities are not formed on the surface of the cover film 13a.

Then, the nickel-plating film 121 and the gold-plating film 122 are formed on the exposed wiring pattern 12 (see Figs. 3A and 3B). This process is the same as in the case of the flexible printed circuit 1a for mounting a light emitting element according to the first embodiment.

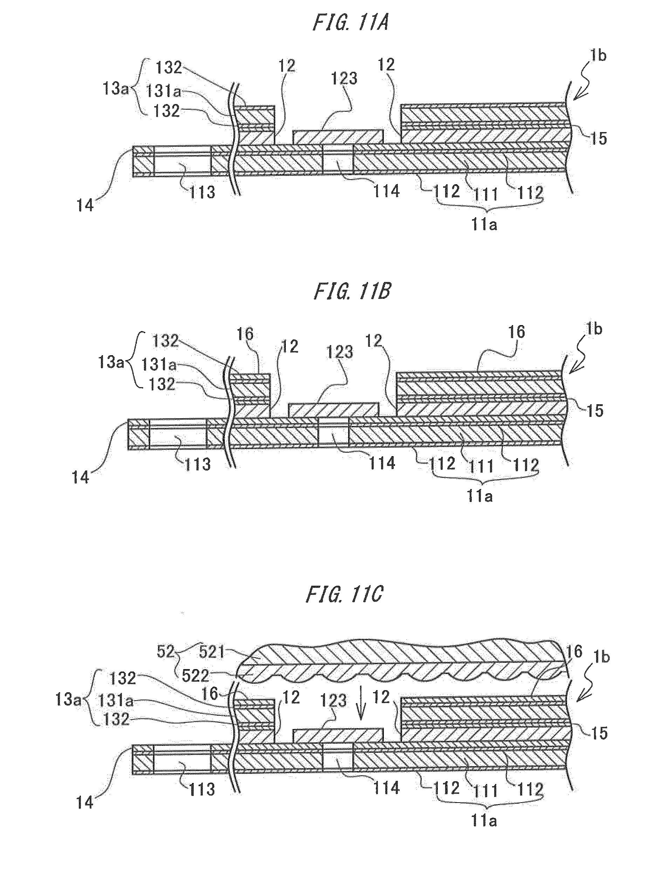

On the other hand, the process in the case where the reflecting film 16 is a film is as follows. Figs. 11A to 12B are schematic cross-sectional views for illustrating the step of forming the cover film 13a and the step of forming the reflecting film 16 in the case where the reflecting film 16 is a film. First, as shown in Fig. 11A, the cover film 13a is applied to the surface of the base film 11a and wiring pattern 12. This process is the same as that in the first embodiment. Then, as shown in Fig. 11B, a film that serves as the reflecting film 16 is applied to the surface of the cover film 13a. This process is the same as the process of applying the cover film 13a in the first embodiment except for that the object to which the film is applied is different.

In the case where irregularities are not formed on the surface of the reflecting film 16, then, a curing process is performed. By this curing process, the thermosetting adhesive 15 between the cover film 13a and the base film 11a and wiring pattern 12 is set. In the case where the film serving as the reflecting film 16 is also bonded by a thermosetting adhesive, the adhesive to bond the reflecting film 16 to the cover film 13a is also set in this curing process.

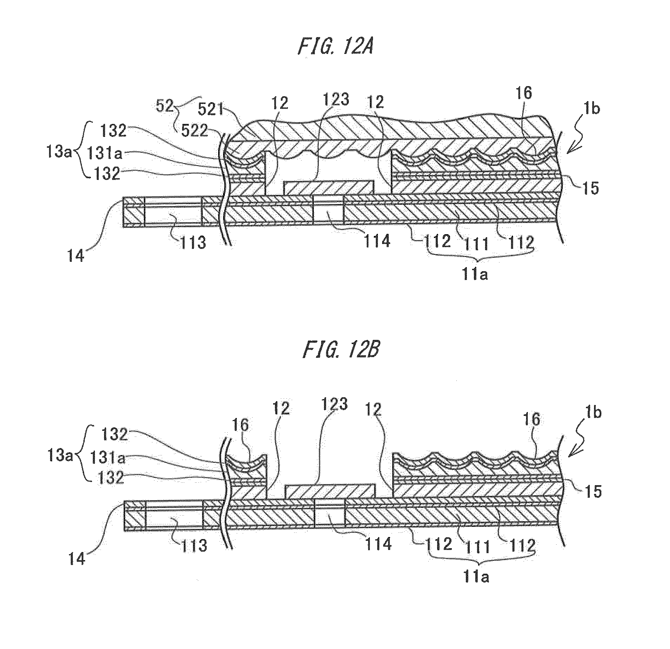

In the case where irregularities are formed on the surface of the reflecting film 16, the irregularities are formed in advance of the curing process. The irregularities can be formed by pressing the transfer mold 52 against the surface of the reflecting film 16 as shown in Figs. 11C and 12A. The configuration of the transfer mold 52 has already been described. When the transfer mold 52 is pressed against the reflecting film 16, the irregularities on the surface of the glass cloth 522 are transferred to the surface of the reflecting film 16. Through this process, the irregularities are formed on the surface of the reflecting film 16 as shown in Fig. 12B. Then, the curing process is performed.

In this way, the cover film 13a is disposed on the surface of the base film 11a and wiring pattern 12, and the reflecting film 16 is disposed on the surface of the cover film 13a.

Then, the nickel-plating film 121 is formed on the exposed wiring pattern 12, and the gold-plating film 122 is formed on the surface of the nickel-plating film 121 (see Figs. 3A and 3B).

Through the process described above, the flexible printed circuit 1b for mounting a light emitting element according to the second embodiment is manufactured.

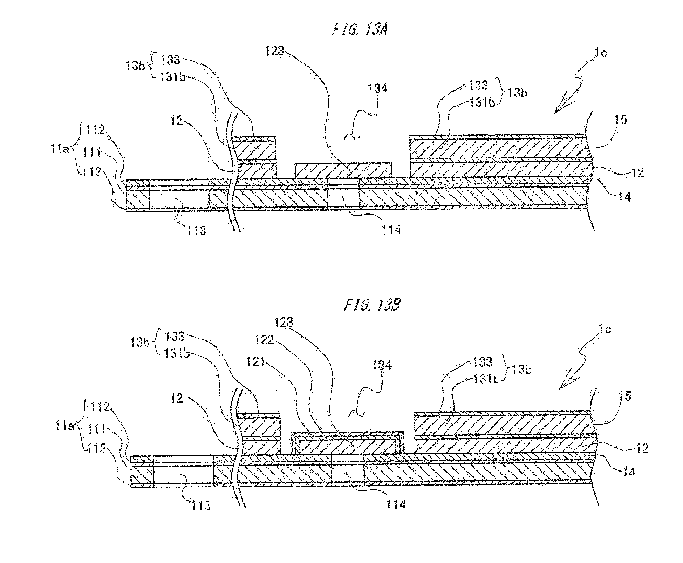

Next, the step of forming the cover film 13b of the flexible printed circuit 1c for mounting a light emitting element according to the third embodiment will be described with reference to Figs. 13A and 13B. Figs. 13A and 13B are schematic cross-sectional views for illustrating the step of forming the cover film 13b of the flexible printed circuit 1c for mounting a light emitting element according to the third embodiment.

As shown in Fig. 13A, first, the cover film 13b is formed on the surface of the base film 11a and wiring pattern 12. For example, first, the adhesive 15 is applied to the surface of the cover film 13b facing the base film 11a and wiring pattern 12. Then, the cover film 13b is bonded to the surface of the base film 11a and wiring pattern 12 by the applied adhesive 15. The adhesive 15 can be any of various well-known thermosetting adhesives, for example. The cover film 13b has a laminate structure comprising the film-shaped substrate 131b and the reflecting film 133 formed on a surface of the substrate 131. The substrate 131b is made of a resin material. The reflecting film 133 can be a film containing titanium oxide. The cover film 13b and the adhesive 15 applied thereto are previously shaped to have a predetermined shape and predetermined dimensions (that is, so as to have the shape and the dimensions of the region to be covered by the cover film 13b) and have the openings 134 previously formed therein, Then, the cover film 13b is positioned on and bonded to the surface of the base film 11a and wiring pattern 12. For example, the cover film 13b is bonded to the surface of the base film 11a and wiring pattern 12 by thermo-compression bonding. Then, the thermosetting adhesive between the cover film 13b and the base film 11a and wiring pattern 12 is set in a curing process. In this way, the cover film 13b is bonded to the surface of the base film 11a and wiring pattern 12.

Then, as shown in Fig. 13B, the nickel-plating film 121 is formed on the exposed wiring pattern 12, and the gold-plating film 122 is formed on the surface of the nickel-plating film 121. This process is the same as in the case of the flexible printed circuit 1a for mounting a light emitting element according to the first embodiment.

The step of forming the cover film 13a of the flexible printed circuits 1d and 1e for mounting a light emitting element according to the fourth and fifth embodiments and the step of plating the wiring pattern 12 of the same are the same as those of the flexible printed circuit 1a for mounting a light emitting element according to the first embodiment. Therefore, descriptions thereof will be omitted.

The flexible printed circuits 1a to 1e for mounting a light emitting element according to embodiments of the present invention have the following advantages.

The base film 11a and the cover film 13a have the substrates 111 and 131a made of a metal material, respectively. Metal materials have higher thermal conductivities than resin materials, so that the heat generated by the mounted light emitting element 20 can be quickly radiated. Therefore, the properties of the light emitting element 20 can be prevented from being deteriorated by heat.

The surface of the cover film 13a produces specular reflection or diffuse reflection of light. As an alternative, the substantially white reflecting film 16 (133) is formed on the surface of the cover film 13a (13b). With such a configuration, more of the light emitted by the light emitting element 20 can be reflected rather than absorbed. Therefore, the light emitted by the light emitting element 20 can be efficiently used.

As the white pigment forming the white reflecting layer of the reflecting film 16 or 133, other inorganic pigments than titanium oxide, such as calcium carbonate, magnesium carbonate, zinc oxide and magnesium oxide can also be used to enhance the diffuse reflection of light and increase the amount of reflected light. The film containing titanium oxide described above is required to be made of a resin containing the white pigment described above that can be applied to a polyimide film and dried and set and is highly adhesive. As such a resin, silicone resins or polyurethane resins are preferably used.

As described above, the flexible printed circuits 1a to 1e for mounting a light emitting element according to embodiments of the present invention can prevent the temperature of the mounted light emitting element 20 from increasing and allow efficient use of the light emitted by the light emitting element 20.

Furthermore, the number of light emitting elements 20 mounted on the flexible printed circuits 1a to 1e for mounting a light emitting element according to embodiments can be reduced, and the cost can be reduced. For example, with the configuration in which the surface of the cover film 13a (13b) or the reflecting film 16 (133) has no irregularities, the light emitted by the light emitting element 20 is specularly reflected or diffuse-reflected by the surface of the cover film 13a or the reflecting film 16 (133). Therefore, the amount of light wasted can be reduced, and the light emitted by a light source incorporating the flexible printed circuits 1a to 1e for mounting a light emitting element according to embodiments can be efficiently used.

Therefore, the number of light emitting elements 20 mounted on the flexible printed circuits 1a to 1e for mounting a light emitting element according to embodiments can be reduced. On the other hand, with the configuration in which the surface of the cover film 13a or the reflecting film 16 (133) has irregularities, the light emitted by the light emitting element 20 is diffuse-reflected by the surface of the cover film 13a or the reflecting film 16 (133) and becomes less directive, so that the nonuniformity of the in-plane light intensity distribution is reduced. Thus, the plurality of LEDs mounted on the flexible printed circuits 1a to 1e for mounting a light emitting element according to embodiments can be arranged at greater intervals, and therefore, the number of light emitting elements 20 can be reduced.

Metal materials, such as aluminum, are inexpensive compared with resin materials, such as polyimide. Therefore, if at least one of the base film 11a and the cover film 13a is made of a metal material, the parts cost can be reduced compared with the configuration in which both films are made of a resin material.

### (Sixth Embodiment)

With the flexible printed circuits 1a, 1b, 1d and 1e for mounting a light emitting element according to the first, second, fourth and fifth embodiments described above, the cover film 13a comprises the substrate 131a made of a metal. Therefore, the flexible printed circuits 1a, 1b, 1d and 1e for mounting a light emitting element have a problem that the film of the adhesive 15, which is an insulating layer, is disposed between the substrate 131a made of a metal material and the wiring pattern 12 formed by a copper foil, and a parasitic stray capacitance is formed between the substrate 131a and the wiring pattern 12 to make the circuit operation unstable. To solve the problem, a wire in the wiring pattern 12 that is at the ground potential (referred to as a grounding wire 19, hereinafter) can be electrically connected to the substrate 131a made of a metal material at an appropriate part. A similar measure is needed for the substrate 111 of the base film and the wiring pattern 12. Next, this measure will be described as an embodiment.

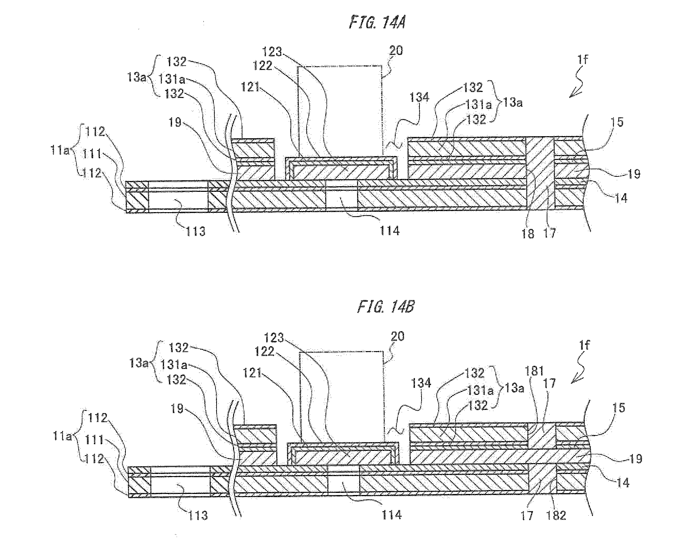

A flexible printed circuits 1f and 1g for mounting a light emitting element according to a sixth embodiment has a structure in which at least one of the substrate 131a, which is made of a metal, of the cover film 13a and the substrate 111, which is made of a metal, of the base film 11a is electrically connected to the grounding wire 19 in the wiring pattern 12. In short, at least one of the substrate 131a of the cover film 13a and the substrate 111 of the base film 11a is connected to be at the same potential as the grounding wire 19. In the following, configurations according to this embodiment will be described with reference to Figs. 14A to 15B.

Fig. 14A is a schematic cross-sectional view showing a configuration of the flexible printed circuit 1f for mounting a light emitting element according to an example of the sixth embodiment. The flexible printed circuit 1f for mounting a light emitting element according to this example of the sixth embodiment is the flexible printed circuit 1a for mounting a light emitting element according to the first embodiment in which a through-hole 18 that penetrates the cover film 13a, the grounding wire 19 and the base film 11a is formed and filled with a conductive paste 17 that electrically connects the grounding wire 19, the substrate 111 of the base film and the substrate 131a of the cover film to each other.

Specifically, the flexible printed circuit 1f for mounting a light emitting element is manufactured as follows. First, the through-hole 18 (a circular hole) having a diameter of 1.0 mm is formed in the flexible printed circuit 1a for mounting a light emitting element according to the first embodiment with a guide hole punching machine. Then, the through-hole 18 is filled with the conductive paste (conductive silver paste SV manufactured by Harima Chemicals Group, Inc.) 17 by printing, and the conductive paste 17 is hardened in a predetermined manner. The surface of the conductive paste 17 rose from the through-hole 18 is preferably planed to be substantially flush with the surface of the surrounding base film 11a or the cover film 13a and then coated with an insulating resin for insulation.

The grounding wire 19 is a wire to drive the light emitting element 20 and has a width of approximately 1.5 mm. From consideration of the heat radiating effect and the shielding effect, one through-hole 18 may be formed for each set of several light emitting elements 20.

Fig. 14B is a schematic cross-sectional view showing a configuration of the flexible printed circuit If for mounting a light emitting element according to a first alternative example of the sixth embodiment. The flexible printed circuit If for mounting a light emitting element according to this alternative example is manufactured in a different manufacturing method than the method of manufacturing the flexible printed circuit If for mounting a light emitting element shown in Fig. 14A described above.

The method of manufacturing the flexible printed circuit 1f for mounting a light emitting element according to this alternative example is as follows. A through-hole 181 and a through-hole 182 are machined in the cover film 13a and the base film 11a, respectively, at positions corresponding to a predetermined part of the grounding wire 19. The machining is performed using an aluminum etchant if the substrates 111 and 131a are made of aluminum.

Furthermore, the protective film 132 of the cover film and the adhesive 14 is shaved to expose the grounding wire 19 to finish the through-holes 181 and 182. Then, the through-holes 181 and 182 are filled with the conductive paste 17 by printing, and the filled conductive paste 17 is hardened in a predetermined thermosetting manner. In this way, the substrate 131a of the cover film, the substrate 111 of the base film and the grounding wire 19 are electrically connected to each other. This alternative example shown in Fig. 14B does not involve the hole machining in the grounding wire 19, so that the electrical connection can be easily formed even if the grounding wire 19 is a fine line.

As a method of manufacturing the flexible printed circuit 1f for mounting a light emitting element shown in Fig. 14B, the following method is also preferred from the viewpoint of mass production. According to the method, the through-hole 181 is formed in the cover film 13a coated with the adhesive 15 at a position corresponding to the grounding wire 19 in the step of forming the opening 134 described in the first embodiment in the same process as the process of forming the opening 134. Furthermore, the through-hole 182 is formed in the base film 11a coated with the adhesive 14 at a position corresponding to the grounding wire 19 in the step of forming the device hole 114 in the same process as the process of forming the device hole 114. The flexible printed circuit 1f for mounting a light emitting element is formed of the resulting cover film 13a and base film 11a in the method described in the first embodiment. Then, the electrical connection in the through-holes 181 and 182 can be formed by the conductive paste 17 to complete the flexible printed circuit 1f for mounting a light emitting element. This manufacturing method is suitable for mass production because the through-holes 181 and 182 are formed in the process of forming the opening 134 and the device hole 114 described above, and therefore the number of machining steps does not significantly increase.

The examples described above can be readily applied to the structure in which the surface of the cover film 13a has irregularities shown in Fig. 2B.

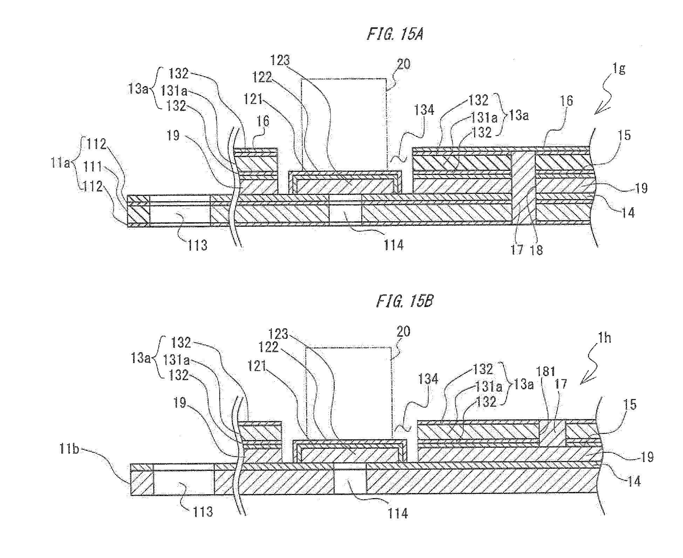

Fig. 15A is a schematic cross-sectional view showing a configuration of the flexible printed circuit 1g for mounting a light emitting element according to a second alternative example of the sixth embodiment. The flexible printed circuit 1g for mounting a light emitting element according to this alternative example of the sixth embodiment is the flexible printed circuit 1b for mounting a light emitting element according to the second embodiment in which the grounding wire 19, the substrate 111 of the base film and the substrate 131a of the cover film are electrically connected to each other. A method of manufacturing the flexible printed circuit 1g for mounting a light emitting element is based on the method of manufacturing the flexible printed circuit 1f for mounting a light emitting element shown in Fig. 14A and further comprises the step of forming the reflecting film 16 according to the second embodiment in the method described above with reference to Fig. 10B. The flexible printed circuit 1g for mounting a light emitting element according to the second alternative example can be easily manufactured in this method.

Fig. 15B is a schematic cross-sectional view showing a configuration of a flexible printed circuit 1h for mounting a light emitting element according to a third alternative example of the sixth embodiment. The flexible printed circuit 1h for mounting a light emitting element according to this alternative example is the flexible printed circuit 1d for mounting a light emitting element according to the fourth embodiment of the present invention in which the grounding wire 19 and the substrate 131a of the cover film are electrically connected to each other. A method of manufacturing the flexible printed circuit 1h for mounting a light emitting element is based on the method of manufacturing the flexible printed circuit 1d for mounting a light emitting element according to the fourth embodiment shown in Figs. 5A and 5B and further comprises a step of forming the through-hole 181 that reaches the grounding wire 19 in the cover film 13a. The same method as that for the through-hole 181 shown in Fig. 14B can be used to form the through-hole 181 and fill the through-hole 181 with the conductive paste and harden the conductive paste. In this way, the flexible printed circuit 1h for mounting a light emitting element can be completed. Of course, the structure and the manufacturing method can also be applied to the flexible printed circuit 1e for mounting a light emitting element according to the fifth embodiment. The flexible printed circuit 1f for mounting a light emitting element shown in Fig. 14B without the through-hole 182 can have this configuration, in which the through-hole 181 formed in the cover film 13a is used to connect only the substrate 131a made of a metal material and the grounding wire 19 to each other.

### (Seventh Embodiment)

An example of a seventh embodiment of a capsule endoscope 301, which is an electronic apparatus incorporating an LED illuminator 300 comprising a plurality of light emitting elements mounted on any of the flexible printed circuits 1a to 1h for mounting a light emitting element (denoted by reference symbol 1x hereinafter) according to the above-described embodiments of the present invention having a surface with a high reflectance, and another example of the seventh embodiment is a vehicle lighting apparatus 331 incorporating an LED illuminator 330 comprising one large light emitting element 332 mounted on the flexible printed circuit 1x for mounting a light emitting element.

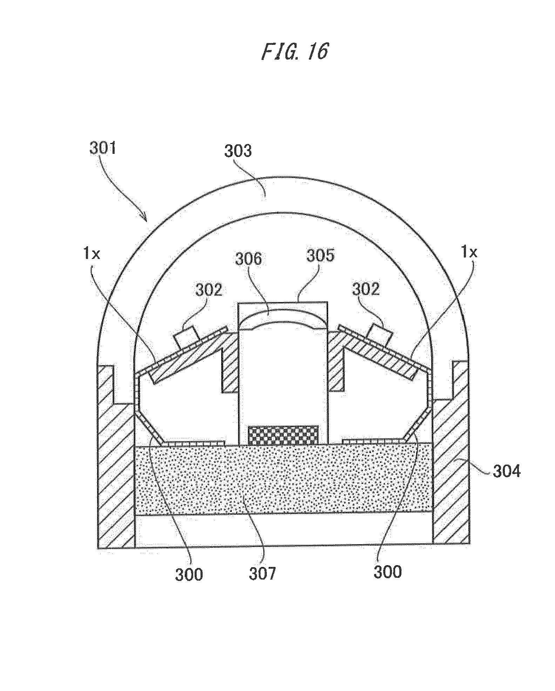

Fig. 16 is a schematic cross-sectional view showing a configuration of the capsule endoscope 301 according to this embodiment of the present invention. The capsule endoscope 301 has a hermetic container comprising a transparent dome 303 and a cylindrical main body 304. An endoscope camera 305 having a substantially cylindrical shape is mounted on a support table 307 at the center in the transparent dome 303. The LED illuminator 300 having a plurality of light emitting elements 302 is firmly fixed to the support table 307 in such a manner that the light emitting elements 302 surround a lens part 306 of the endoscope camera 305. The LED illuminator 300 comprises the flexible printed circuit 1x for mounting a light emitting element according to any of the above-described embodiments of the present invention. In the LED illuminator 300, LED elements serving as the light emitting elements 20 are mounted on the flexible printed circuit 1x (see, for example, Figs. 1 to 6). With such a configuration, because of the high surface reflectance of the flexible printed circuit 1x for mounting a light emitting element, the light emitted by the light emitting elements 302 can be efficiently reflected toward the transparent dome. Furthermore, the heat generated by the light emitting elements 302 can be transferred to the support table 307. Furthermore, the flexible printed circuit 1x for mounting a light emitting element has a superior electromagnetic shielding capability and therefore can effectively reduce the effect of electromagnetic noise on the image information acquired by the endoscope camera in which a high frequency signal processing occurs.

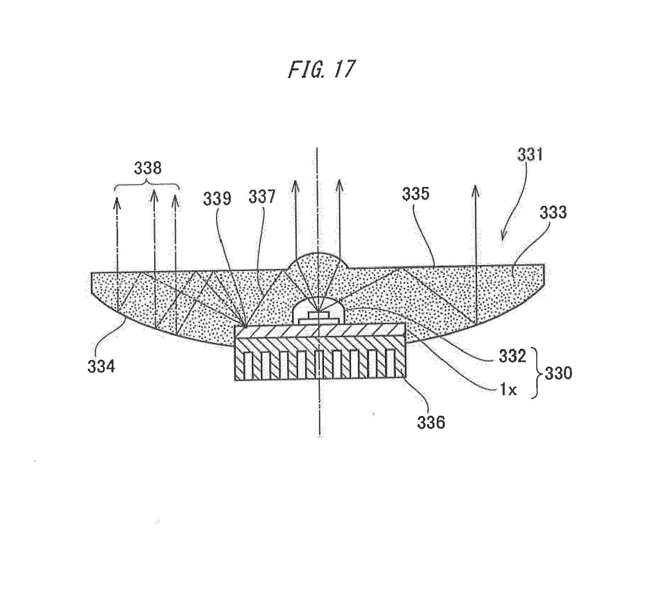

Fig. 17 is a schematic cross-sectional view showing a configuration of the vehicle lighting apparatus 331 according to this embodiment of the present invention. The vehicle lighting apparatus 331 according to this embodiment of the present invention is designed to direct the light emitted by the light emitting element 332 mounted in the LED illuminator 330 toward the front of the vehicle lighting apparatus 331 by the action of a transparent member 333 disposed in front of the LED illuminator 330. The LED illuminator 330 comprises the flexible printed circuit 1x for mounting a light emitting element according to any of the above-described embodiments of the present invention having a high surface reflectance. In the LED illuminator 330, LED elements serving as the light emitting elements 20 are mounted on the flexible printed circuit 1x (see, for example, Figs. 1 to 6). Therefore, for example, a ray of light 337, which is part of the light emitted by the light emitting element 332, is reflected by a front surface 335 of the transparent member 333 and reaches a point 339 on the surface of the flexible printed circuit 1x for mounting a light emitting element or a back surface 334 of the transparent member 333. The ray of light 337 is diffuse-reflected at the point 339 or the back surface 334 of the transparent member 333 and travels in the form of diffuse-reflected light 338 and then can exit the transparent member 333. The heat generated by the light emitting element 332 can be efficiently transferred to a heat sink 336 through the flexible printed circuit 1x for mounting a light emitting element having the substrate 131a made of a metal material.

As described above, the capsule endoscope 301 and the vehicle lighting apparatus 331 according to the seventh embodiment are electronic apparatuses that have a high surface reflectance and a high heat radiation capability owing to the flexible printed circuit 1x for mounting a light emitting element according to the above-described embodiments of the present invention and are less affected by electromagnetic noise.

Although embodiments of the present invention have been described above in detail, the embodiments described above are intended only to illustrate specific implementations of the present invention. These embodiments should not be construed as limiting the technical scope of the present invention. In other words, the present invention can have various other embodiments without departing from the technical spirit and primary characteristics thereof. For example, although the embodiments (including the examples thereof) described above concern TAB flexible printed circuits with sprocket holes formed in the base film, the present invention can equally be applied to other flexible printed circuits than the TAB flexible printed circuits. Furthermore, although the embodiments (including the examples thereof) described above concern flexible printed circuits, the present invention can equally be applied to printed circuits having no flexibility (so-called rigid printed circuits).

The present invention provides techniques advantageous for a flexible printed circuit for mounting a light emitting element, a capsule endoscope and a vehicle lighting apparatus incorporating the same, and a method of manufacturing the flexible printed circuit. In particular, the present invention provides techniques advantageous for a flexible printed circuit for mounting a light emitting element, such as an LED, a capsule endoscope and a vehicle lighting apparatus incorporating the same, and a method of manufacturing the flexible printed circuit.

According to the present invention, the temperature of the mounted light emitting element can be prevented from increasing, and the light emitted by the light emitting element can be efficiently used. According to the present invention, furthermore, a flexible printed circuit for mounting a light emitting element that has a high electromagnetic shielding capability and can be bent, an illumination apparatus, a capsule endoscope and a vehicle lighting apparatus can be manufactured.

A flexible printed circuit for mounting a light emitting element has a base film, a wiring pattern formed on a surface of the base film, and a cover film that covers the base film and the wiring pattern. At least one of the base film and the cover film has a substrate comprising a metal. The cover film has such surface properties as to produce specular reflection or diffuse reflection of light or has a substantially white reflecting film on a surface of the cover film.

## Claims

1. A flexible printed circuit for mounting a light emitting element, comprising:
a base film having a substrate comprising a metal material;
a wiring pattern formed on a surface of said base film; and
a cover film that has such a surface property as to produce specular reflection or diffuse reflection of light and covers said wiring pattern.

2. The flexible printed circuit for mounting a light emitting element according to claim 1, wherein said cover film has a substrate comprising a resin material and a substantially white reflecting film formed on a surface of said substrate.

3. The flexible printed circuit for mounting a light emitting element according to claim 1, wherein said cover film has a substrate comprising a metal material.

4. The flexible printed circuit for mounting a light emitting element according to claim 3, wherein irregularities are formed on a surface of said cover film.

5. The flexible printed circuit for mounting a light emitting element according to claim 4, wherein either said cover film further has a substantially white reflecting film formed on a surface of said substrate or said irregularities on the surface are formed by depressions having a depth of 15 to 80 µm arranged in pitch of 100 to 3000 µm.

6. The flexible printed circuit for mounting a light emitting element according to claim 3, wherein at least one of said substrate comprising a metal material of said base film and said substrate comprising a metal material of said cover film is electrically connected to a grounding wire in said wiring pattern.

7. The flexible printed circuit for mounting a light emitting element according to claim 6, wherein a through-hole is formed to penetrate said substrate comprising a metal material of said base film, said wiring pattern and said substrate comprising a metal material of said cover film and is filled with a conductive paste, and
said substrate comprising a metal material of said base film and said substrate comprising a metal material of said cover film are electrically connected to said grounding wire by said conductive paste.

8. The flexible printed circuit for mounting a light emitting element according to claim 7, wherein said cover film further has a substantially white reflecting film formed on a surface of said substrate, and
said through-hole and said conductive paste filling said through-hole are covered with said reflecting film.

9. The flexible printed circuit for mounting a light emitting element according to claim 6, wherein a through-hole is formed in at least one of said substrate comprising a metal material of said base film and said substrate comprising a metal material of said cover film and is filled with a conductive paste, and
said substrate comprising a metal material of said base film and said substrate comprising a metal material of said cover film are electrically connected to said grounding wire by said conductive paste.

10. The flexible printed circuit for mounting a light emitting element according to claim 9, wherein said cover film further has a substantially white reflecting film formed on a surface of said substrate, and
said through-hole and said conductive paste filling said through-hole are covered with said reflecting film.

11. A flexible printed circuit for mounting a light emitting element, comprising:
a base film having a substrate comprising a resin material;
a wiring pattern formed on a surface of said base film; and
a cover film that has a substrate comprising a metal material, has such a surface property as to produce specular reflection or diffuse reflection of light and covers said wiring pattern.

12. The flexible printed circuit for mounting a light emitting element according to claim 11, wherein irregularities are formed on a surface of said cover film.

13. The flexible printed circuit for mounting a light emitting element according to claim 12, wherein said irregularities on the surface are formed by depressions having a depth of 15 to 80 µm arranged in pitch of 100 to 3000 µm.

14. The flexible printed circuit for mounting a light emitting element according to claim 11, wherein a through-hole that reaches a grounding pattern in said wiring pattern is formed in said substrate comprising a metal material of said cover film and is filled with a conductive paste, and
said substrate comprising a metal material of said cover film is electrically connected to said grounding wire by said conductive paste.

15. An illumination apparatus or a capsule endoscope or a vehicle lighting apparatus, comprising:
a flexible printed circuit for mounting a light emitting element having a base film having a substrate comprising either
a metal material, a wiring pattern formed on a surface of said base film, and a cover film that has such a surface property as to produce specular reflection or diffuse reflection of light and covers said wiring pattern;
a resin material, a wiring pattern formed on a surface of said base film, and a cover film that has a substrate comprising a metal material, has such a surface property as to produce specular reflection or diffuse reflection of light and covers said wiring pattern;
and a light emitting element mounted on said flexible printed circuit for mounting a light emitting element.
